Europäisches Patentamt

European Patent Office

Office européen des brevets

(11) Numéro de publication: **0 197 817**
**A1**

# (12) DEMANDE DE BREVET EUROPEEN

(21) Numéro de dépôt: **86400529.3**

(22) Date de dépôt: **12.03.86**

(51) Int. Cl.⁴: **H 05 K 7/20**

(30) Priorité: **18.03.85 FR 8503970**

(43) Date de publication de la demande:
**15.10.86 Bulletin 86/42**

(84) Etats contractants désignés:
**DE GB IT**

(71) Demandeur: **SOCAPEX**
**10 bis, quai Léon Blum**
**F-92153 Suresnes(FR)**

(72) Inventeur: **Bricaud, Hervé**
**5, rue de Saint-Germain**
**F-78370 Plaisir(FR)**

(72) Inventeur: **L'Henaff, Patrick**
**9, rue Louis Duperrey**
**F-94320 Thiais(FR)**

(74) Mandataire: **Brullé, Jean et al,**
**Service Brevets Bendix 44, rue François 1er**
**F-75008 Paris(FR)**

(54) **Carte de circuit imprimé à échangeur thermique et procédé de fabrication d'une telle carte.**

(57) La présente invention concerne une carte de circuit imprimé à échangeur thermique incorporé.

Cette carte comprend solidaires l'un de l'autre, un circuit mono ou multicouches et un drain thermique (10, 11) comportant un système de canalisation (17) permettant la circulation d'un fluide caloporteur.

Application aux équipements électroniques comportant un grand nombre de cartes.

./...

FIG_1

1

## CARTE DE CIRCUIT IMPRIME A ECHANGEUR THERMIQUE
## ET PROCEDE DE FABRICATION D'UNE TELLE CARTE

La présente invention concerne une carte de circuit imprimé à échangeur thermique incorporé dite ci-après carte imprimée ainsi qu'un procédé de fabrication d'une telle carte.

En effet, des problèmes de dissipation thermique se pose notamment dans les appareils ou équipements comportant un grand nombre de cartes imprimées munies de composants électroniques. Parmi ces composants, certains d'entre eux dissipent une quantité de chaleur importante qu'il convient d'évacuer dans les meilleures conditions possibles afin de maintenir lesdits composants dans des conditions de fonctionnement acceptables.

Pour remédier à cet inconvénient, on a proposé, notamment dans la demande de brevet française N° 82 05253 au nom de la Demanderesse, une carte imprimée électrique et thermique comportant un drain thermoconducteur. Cette carte assure le transfert des calories par conduction à travers le drain réalisé généralement en métal, jusque sur les bords latéraux de la carte qui sont couplés thermiquement sur les parois froides de l'équipement à l'aide par exemple de connecteurs guide-cartes thermiques. Ce procédé, bien que plus efficace que les systèmes de refroidissement par convection forcée antérieurement utilisés, présente un certain nombre d'inconvénients. En effet, il met en oeuvre une chaîne de conduction thermique comportant un nombre élevé de maillons constitués par :

- la résistance de couplage $Rc$ du boîtier sur la carte imprimée,

- la résistance de conduction transversale $Rt$ de la carte imprimée faisant intervenir l'épaisseur du drain et, dans le cas des composants brasés à plat, celle du circuit imprimé,

- la résistance de conduction longitudinale $Rl$ du drain de la carte, résistance qui est d'autant plus élevée que les dimensions de la carte sont grandes,

- la résistance de couplage $Rf$ des bords latéraux du drain sur les parois froides de l'équipement, et

- la résistance de conduction Rp du bâti de l'équipement entre les parois froides et le puit thermique.

Or, la somme des pertes en ligne provoquées par chacun des maillons ci-dessus grève le bilan thermique de l'ensemble. De plus, les résistances de conduction Rl, Rf et Rp constituent une contrainte limitative pour la puissance maximale dissipable sur la carte. D'autre part, l'influence mutuelle des échauffements des composants d'une même carte par le biais du drain thermoconducteur provoque le long de celui-ci un gradient de température défavorable aux composants les plus éloignés des bords latéraux de la carte.

La présente invention a pour but de remédier à cet inconvient en proposant une carte imprimée à échangeur thermique incorporé présentant un excellent coefficient d'échange thermique entre les composants électroniques de la carte et le puit thermique du système.

En conséquence, la présente invention a pour objet une carte imprimée à échangeur thermique incorporé comprenant, solidaire l'un de l'autre, un circuit mono ou multicouches et un drain thermique, caractérisée en ce que le drain thermique comporte un système de canalisation permettant la circulation d'un fluide caloporteur.

Selon un mode de réalisation préférentiel, le drain thermique comportant le système de canalisation est constitué d'une plaque munie d'un réseau de canaux et d'une plaque de fermeture, les deux plaques étant solidaires l'une de l'autre. Le réseau de canaux peut être un réseau série constitué par un seul canal continu en forme de méandres. Toutefois pour diminuer la perte de charge globale du réseau de canalisation de la carte imprimée, le réseau de canaux peut être un réseau parallèle constitué de plusieurs canaux parallèles entre eux débouchant dans deux canaux latéraux communs à tous les canaux.

Selon une autre caractéristique de la présente invention, la plaque de fermeture ou la plaque munie du réseau de canaux comporte, à chaque extrémité du réseau de canaux, un orifice permettant le raccordement dudit réseau à un dispositif d'alimentation en fluide caloporteur. De préférence, les orifices de raccordement au dispositif d'alimentation en fluide caloporteur sont prévus sur une bordure au moins de la carte, bordure qui comporte également des emplacements de connexions électriques.

Ainsi, la structure de la carte imprimée décrite ci-dessus assure un excellent coefficient d'échange thermique, par l'intermédiaire d'une chaîne de conduction très courte, entre les composants électroniques de la carte et le fluide caloporteur dont la circulation dans les canaux du drain permet le transfert des calories vers l'extérieur. En effet, dans ce cas la chaîne de conduction thermique se compose de deux maillons, à savoir :

- la résistance de couplage Rc du boîtier sur la carte imprimée et,
- la résistance de conduction transversale Rt de la carte imprimée qui fait intervenir l'épaisseur du drain et, dans le cas des composants brasés à plat, celle du circuit imprimé.

D'autre part, avec la carte à circulation de fluide caloporteur décrite ci-dessus, les composants sont quasiment découplés thermiquement les uns des autres, car le fluide caloporteur s'échauffe peu (de l'ordre de 3° pour une carte dissipant 30W). Par ailleurs, en agissant au niveau de la pompe de circulation du fluide caloporteur prévue dans le dispositif d'alimentation en fluide caloporteur, il est possible d'ajuster le débit du fluide à la quantité de calories à évacuer tout en maintenant un faible écart de sa température entre l'entrée et la sortie de la carte. Enfin, la carte qui est maintenue sur toute sa surface à la même température que celle du fluide caloporteur, est dans les mêmes conditions sensiblement plus froide que la carte à drain thermoconducteur. Les échanges thermiques par rayonnement mutuel entre les cartes placées parallèlement dans un même équipement sont donc considérablement réduits, ce qui permet ainsi une grande densité de cartes à l'intérieur d'un même équipement électronique.

De plus, cette carte imprimée à échangeur thermique incorporé permet aussi la régulation en température de composants électroniques spécifiques dont la stabilité des caractéristiques ou des performances est essentiellement liée à la température de fonctionnement. Le système de circulation du fluide caloporteur peut aussi être utilisé comme moyen de préchauffage dans le cas de certaines applications très particulières telles que les systèmes embarqués où une partie ou tout l'équipement électronique peut avoir une température très basse juste avant sa mise en fonctionnement.

Selon une autre caractéristique de la présente invention, on prévoit, entre la plaque de fermeture et la plaque munie du réseau de canaux, une couche de solidarisation et d'étanchéité réalisée de préférence par un tissu de verre époxy pré-imprégné à l'aide, par exemple, d'une résine époxy pré-polymère. Cette couche est utilisée pour réaliser l'assemblage de la plaque de fermeture avec la plaque munie du réseau de canaux. Selon un mode de réalisation préférentiel, la couche de solidarisation et d'étanchéité est munie d'une découpe correspondant totalement ou partiellement au dessin du réseau de canaux. Cette découpe augmente la section des canaux de la valeur de l'épaisseur du tissu et permet donc à la plaque de fermeture d'être directement au contact du fluide caloporteur, ce qui améliore les échanges thermiques au sein de la carte.

La plaque munie du réseau de canaux est réalisée de préférence en métal ou en matière plastique moulable ou déformable à chaud telle que le polyéthersulfone, le polyétherimide ou le polysulfone, et la plaque de fermeture est réalisée en métal. Toutefois, selon une autre caractéristique de la présente invention, la plaque de fermeture est constituée par un circuit imprimé mono ou multicouches réalisé sur un substrat isolant tel que du tissu de verre époxy dont une des faces est entièrement métallisée avec du cuivre par exemple, la face métallisée venant contre la plaque munie du réseau de canaux. Ce circuit imprimé peut être le circuit qui assure toutes les interconnexions électriques de la carte, cumulant ainsi les deux fonctions de plaque de fermeture et d'interconnexions électriques.

D'autre part, lorsque certains composants à reporter sur la carte imprimée sont montés dans des boîtiers céramiques à plots de connexion brasés à plat, la plaque munie du réseau de canaux et la plaque de fermeture sont réalisées en un matériau à coefficient de dilatation thermique adapté à celui de la céramique tel qu'en alliage fer-nickel à 42 % de nickel.

La présente invention concerne également un procédé de fabrication d'une carte imprimée telle que décrite ci-dessus. Sans entrer dans les détails auxquels on pourra se rapporter ci-après, ce procédé est essentiellement remarquable en ce que la plaque munie du réseau de canaux est obtenue en gravant par attaque chimique une plaque plane selon un dessin propre au format de la carte, à l'implantation et à la nature des composants qui devront être portés sur celle-ci. Le réseau de canaux peut également être usiné par fraisage sur machine à commande numérique, lorsque les quantités à produire ne justifient pas la création d'outillage de gravure spécifique au dessin choisi. Au contraire, lorsque les quantités à produire sont très importantes, il est possible soit de mouler la plaque munie du réseau de canaux avec une matière plastique adéquate telle que, par exemple, le polyéthersulfone, le polyétherimide, le polysulfone, soit de fabriquer la plaque munie du réseau de canaux par une opération combinée poinçonnage-emboutissage à partir d'un flanc en tôle métallique ou d'une feuille de matière plastique déformée à chaud.

D'autre part, la plaque munie du réseau de canaux et la plaque de fermeture sont solidarisées l'une avec l'autre soit par collage à l'aide d'une colle époxy par exemple, soit en intercalant entre les deux un tissu de verre époxy du type pré-imprégné à l'aide d'une résine époxy pré-polymère, le passage en température de l'ensemble maintenu pressé réalisant la solidarisation des deux plaques et l'étanchéité du réseau de canalisation. Le circuit imprimé correspondant est ensuite réalisé et assemblé avec ce drain thermique soit par contre-collage, soit en intercalant entre les deux une couche de solidarisation constituée par un tissu de verre époxy du type pré-imprégné à l'aide d'une résine époxy pré-polymère par exemple.

D'autres caractéristiques et avantages de la présente invention apparaîtront à la lecture de la description de divers modes de réalisation donnés à titre illustratif mais non limitatif, description faite avec référence aux dessins ci-annexés dans lesquels :

- la figure 1 est une vue partielle éclatée des éléments constitutifs de la carte imprimée conforme à la présente invention ainsi que d'une fiche de connecteur ;

- la figure 2 est une vue en plan d'un mode de réalisation de la plaque munie d'un réseau série de canaux conformément à la présente invention ;

- la figure 3 est une vue en plan d'un autre mode de réalisation de la plaque munie d'un réseau parallèle de canaux conformément à la présente invention ;

- la figure 4 est une vue partielle en coupe de la carte imprimée à échangeur thermique incorporé selon l'invention équipée de composants brasés à plat et couplés thermiquement, et

- la figure 5 est une vue partielle en coupe de la carte imprimée à échangeur thermique incorporé selon l'invention équipée de composants brasés avec des connexions traversantes et couplés thermiquement.

Pour faciliter la compréhension de la description, sur les figures, les mêmes éléments portent les mêmes références.

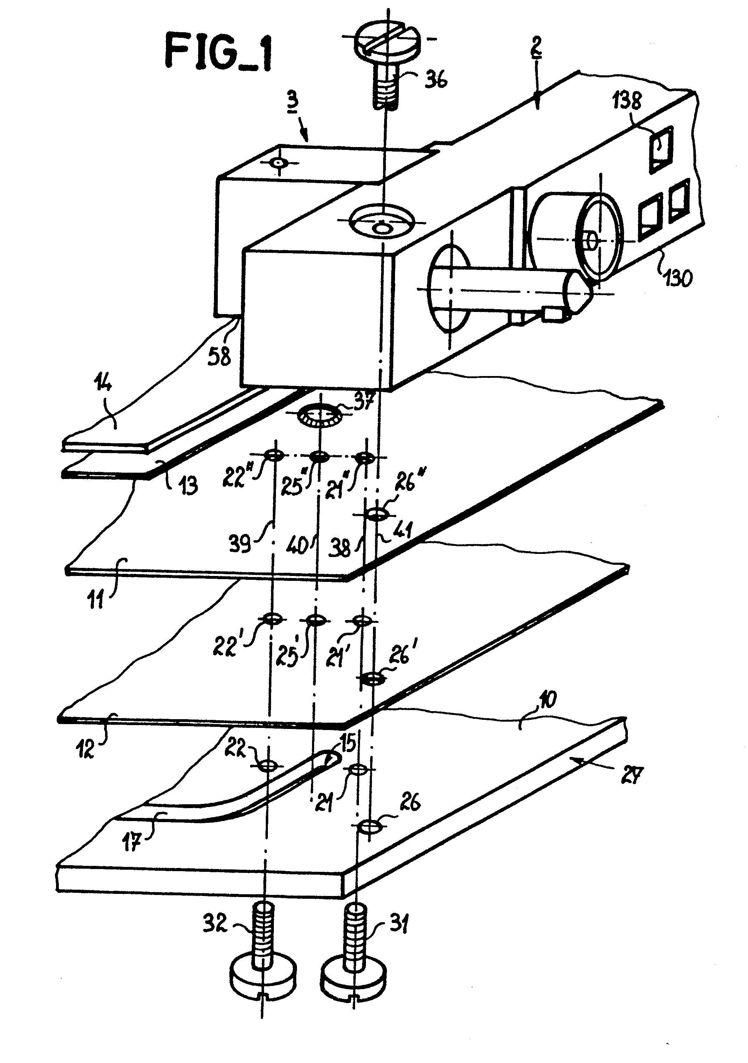

Sur la figure 1 sont représentés, selon une vue éclatée, une carte imprimée 1 à échangeur thermique incorporé ainsi que la fiche 2 du connecteur d'entrée-sortie de la carte et un contact fluidique 3 qui peut être également monté dans la fiche 2 du connecteur d'entrée-sortie de la carte pour raccorder le réseau de canalisation de la carte imprimée à un dispositif d'alimentation en fluide caloporteur non représenté. Un tel connecteur fluidique est décrit, par exemple dans la demande de brevet français déposée le même jour que la présente demande pour "connecteur fluidique miniature". La carte imprimée 1 conforme à la présente invention est constituée essentiellement d'une plaque 10 munie d'un réseau de canaux et d'une plaque de fermeture 11. La plaque munie d'un réseau de canaux est réalisée par exemple en aluminium ou en alliage fer-nickel à 42 % de nickel si le drain doit présenter un coefficient de dilatation adapté à celui de la céramique. L'épaisseur de la plaque 10 est d'environ 1,5 mm. Les canaux 17 creusés dans la plaque 10 ont une profondeur de 1 mm et une largeur de 3 mm environ. La plaque de fermeture 11 a une épaisseur de 0,1 mm environ et est de préférence réalisée en alliage fer-nickel pour des raisons de résistance mécanique. Toutefois, la plaque 10 munie du réseau de canaux et la plaque de fermeture 11 peuvent être réalisées en d'autres métaux. Eventuellement la plaque 10 munie du réseau de canaux peut être réalisée en matière plastique comme cela sera expliqué ci-après.

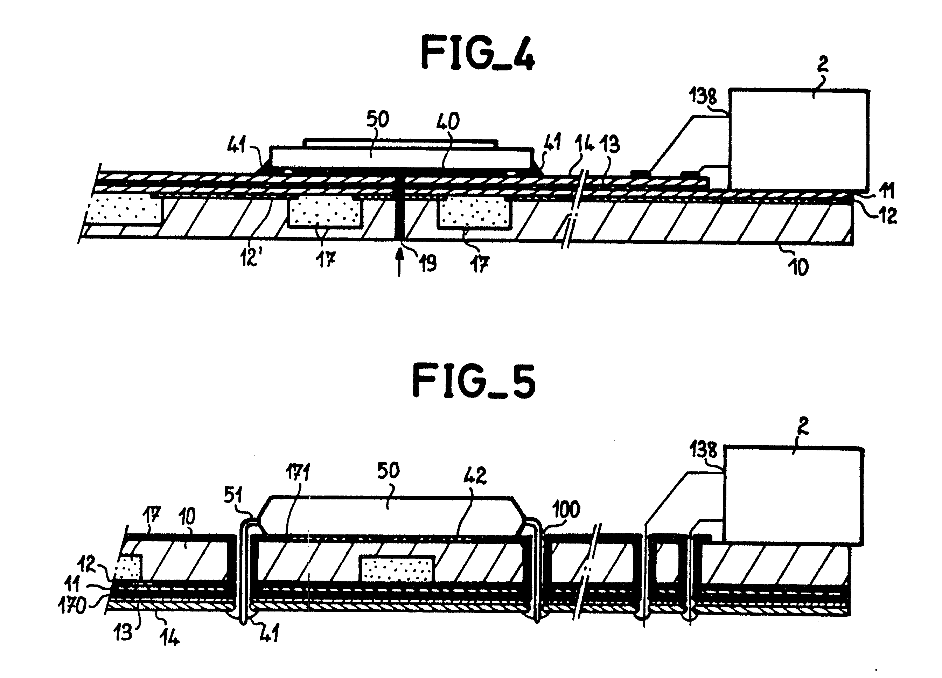

Dans le mode de réalisation représenté à la figure 1, la plaque de fermeture 11 est rendue solidaire de la plaque 10 du côté où débouchent les canaux 17 par l'intermédiaire d'une couche 12 de solidarisation et d'étanchéité constituée par exemple par un tissu imprégné de même découpe que la plaque 11. D'autre part, le circuit imprimé 14 qui peut être un circuit imprimé mono ou multicouches réalisé de manière connue en soi, est rendu solidaire du drain constitué par les plaques 11 et 10 sur la face externe de la plaque de fermeture 11. Toutefois, il est évident pour l'homme de l'art que le circuit imprégné 14 peut être rendu solidaire du drain thermique constitué par les plaques 11 et 10 sur la face externe de la plaque de canalisation 10. Cette solidarisation est réalisée par l'intermédiaire d'une couche de solidarisation 13 constituée d'un tissu pré-imprégné de même découpe que le circuit imprimé 14. D'autre part, au niveau de l'extrémité 15 du réseau de canaux 17, la plaque de fermeture 11 ainsi que le tissu pré-imprégné 12 sont munis de trous respectivement 25' et 25" pour le passage du fluide caloporteur. Les mêmes trous seront réalisés au niveau de l'autre extrémité non représentée du réseau de canaux 17. Les trous 25' et 25" correspondants sont alignés sur l'axe 40 à l'aplomb des extrémités 15, le diamètre du trou 25' étant légèrement inférieur à celui d'un joint d'étanchéité 37 prévu entre ledit trou et le connecteur fluidique 3. Selon un autre mode de réalisation non représenté, le trou de passage du fluide caloporteur peut être réalisé dans la plaque 10 munie du réseau de canalisation. En fait, la position des trous de passage est fonction de la face de la carte imprimée choisie pour reporter la fiche de connecteur 2. D'autre part, pour permettre le raccord du connecteur fluidique 3 incorporé dans la fiche 2 du connecteur d'entrée-sortie la bordure du drain thermique comportant les trous de passage 25' fait saillie par rapport au circuit imprimé 14. Cette structure est particulièrement avantageuse dans le cas des cartes imprimées utilisées avec des composants brasés par report à plat comme représenté sur la figure 4.

D'autre part, les plaques 10 et 11 ainsi que la couche 12 présentent des trous de passage mécanique 21, 22, 26, 21', 22', 26' et 21", 22", 26" pour des vis 31, 32, 36. Ces trous de passage sont respectivement dans l'alignement des axes 38, 39, 41 des trous de fixation non référencés des contacts fluidiques 3 et de l'isolant 130 de la fiche 2.

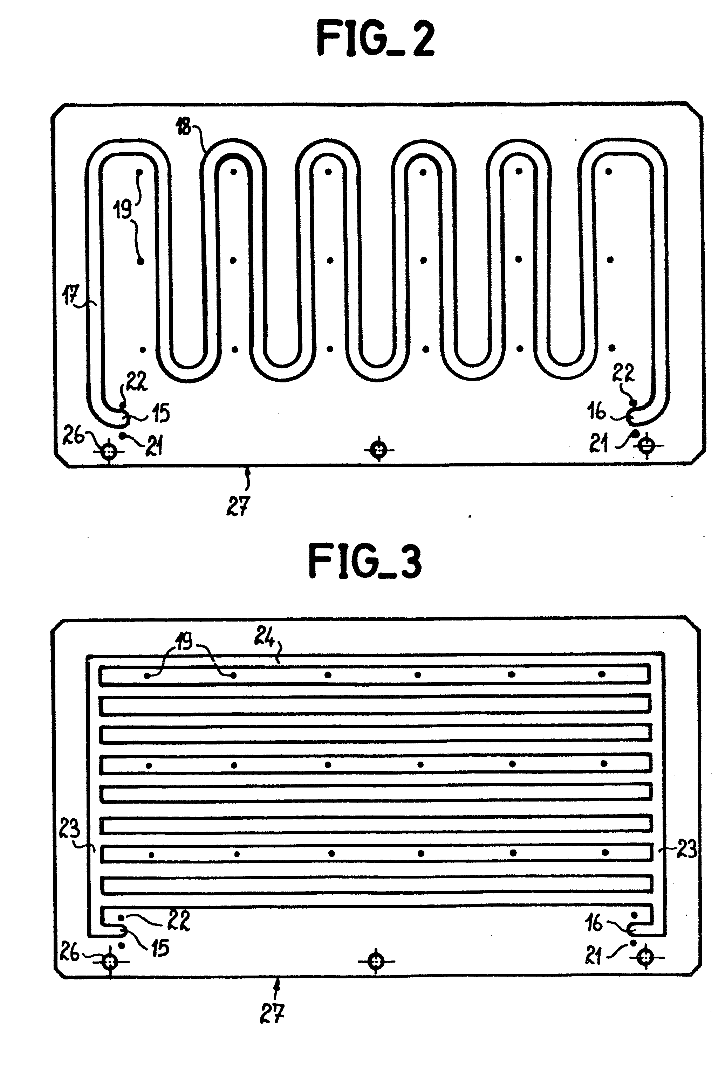

Comme représenté sur les figures 2 et 3, le réseau de canaux 17 de la plaque 10 peut être réalisé de différentes manières. Ainsi, la figure 2 représente un réseau de canaux série qui est réalisé par une seule trace continue reliant les deux extrémités 15 et 16 sous la forme de méandres successifs constitués, par exemple, de portions rectilignes 17 et de parties incurvées 18. Le nombre de méandres est choisi de manière que les extrémités 15 et 16 se trouvent près du bord transversal 27 correspondant au côté du connecteur 2. Cette plaque 10 est munie de trous 19 en dehors du réseau de canaux. Les trous 19 dont le diamètre est d'environ 1 mm, permettent d'injecter une pâte thermoconductrice sous les boîtiers des composants comme cela sera expliqué plus en détail ci-après.

La figure 3 représente un autre mode de réalisation du réseau de canaux. Dans ce cas, le réseau de canaux est un réseau parallèle. Ce dernier est réalisé sous la forme de plusieurs canaux transversaux 24, parallèles entre eux et débouchant de part et d'autre dans deux canaux latéraux 23 communs à tous les canaux 24. Cette configuration, qui permet de diviser le débit du fluide entre tous les canaux transversaux 24, a l'avantage de diminuer la perte de charge globale du réseau de canalisation de la carte imprimée 1.

Les figures 4 et 5 représentent des vues partielles en coupe d'une carte imprimée à échangeur thermique incorporé conforme à la présente invention sur laquelle sont montés des composants électroniques et les bornes de sortie des contacts électriques 138 de la fiche 2 du connecteur d'entrée-sortie. Dans le cas de la figure 4, les composants électroniques et les bornes de sortie des contacts électriques 138 de la fiche 2 du connecteur sont brasés à plat. Dans ce cas, la fiche 2 est montée du côté du circuit imprimé. En conséquence, le drain thermique constitué des plaques 10, 11 et la couche de solidarisation et d'étanchéité 12 présentent, du côté de la fiche 2, à savoir du côté comportant les trous de passage du fluide caloporteur, une partie en saillie par rapport au circuit imprimé 14. D'autre part, pour améliorer la conductibilité thermique entre le composant 50 brasé à plat par les brasures 41 sur le circuit 14 et le drain thermique, on injecte par les trous 19 prévus dans la carte imprimée une pâte 40 de conduction thermique bien connue de l'homme de métier présentant une conductibilité thermique supérieure à celle de l'air.

On constate que, dans le cas de la figure 4, le drain thermique n'a pas besoin d'être isolé électriquement, car le tissu pré-imprégné 13 assure l'isolement électrique entre le circuit imprimé 14 et le drain. Dans ce cas, la chaîne de conduction thermique entre le boîtier et le fluide caloporteur est constituée par :

- la résistance thermique transversale de la plaque de fermeture 11 qui est très mince (0,1 mm) ou celle de la paroi du fond de la canalisation de la plaque 10 lorsque le circuit imprimé est collé de ce côté,

- la résistance transversale du tissu 13 qui est également mince (0,1 mm environ),

-la résistance transversale des interconnexions des pistes de cuivre

du circuit imprimé mince 14, et

-la résistance transversale de la pâte conductrice injectée à l'aide d'une seringue, par exemple, à travers les trous 19 sous la base des boîtiers 50 en appui sur la carte imprimée.

D'autre part, le tissu 13 a subi, au niveau des canaux 17, une découpe 12, qui améliore l'échange thermique entre les composants 5 et le fluide caloporteur.

La figure 5 représente le cas où les composants sont brasés à l'aide de connexions 51 traversant la carte imprimée. Dans ce cas, le circuit imprimé 14, sa couche de solidarisation 13, la plaque de fermeture 11, la couche de solidarisation et d'étanchéité 12 et la plaque 10 sont munis de trous de connexion 100 pour le passage des connexions 51. Dans ce cas, toutefois, la surface du drain et les parois des trous de connexion doivent être isolées électriquement. Cet isolement électrique peut être réalisé de la façon décrite par exemple dans la demande de brevet français 82.05253 au nom de la Demanderesse. Ainsi, cet isolement est réalisé par un enrobage de résine époxy 7, cet enrobage isolant présentant, de préférence, des fenêtres 171 laissant le drain à nu sous le fond des boîtiers 50 des composants. Chacune de ces fenêtres est munie de pâte ou d'un joint thermique 42 connu en soi qui relie thermiquement la base du boîtier au drain à circulation de fluide. La couche d'isolant n'est pas nécessaire au niveau de la bordure de la plaque 10 destinée à recevoir la fiche 2 comme représentée sur la figure 5. Dans ce cas, la fiche 2 étant rapportée du côté de plaque 10, le circuit imprimé et le drain thermique présentent les mêmes dimensions. Comme mentionné ci-dessus, la carte imprimée conforme à la présente invention est destinée principalement à être connectée à un dispositif d'alimentation en fluide caloporteur. Ce dispositif qui n'a pas été représenté et qui forme le puit thermique de l'équipement, est constitué essentiellement par un réservoir de fluide caloporteur et une pompe de circulation. Eventuellement, un échangeur thermique peut compléter le dispositif. Cet échangeur thermique a pour but de réguler la température du fluide caloporteur lorsque celui-ci circule en circuit fermé. Cependant il est évident pour l'homme de l'art que ce dispositif est inutile dans le cas de fluide consommable ou de circulation en fluide dit perdu.

En fonction du type d'application de l'équipement électronique le puit thermique sera spécialement créé ou pourra être prélevé sur un circuit de fluide disponible dont la fonction principale peut être, par exemple :

- le circuit d'huile d'organes mécaniques
- le circuit de refroidissement d'un moteur
- le carburant d'un moteur ou d'un réacteur.

En fonction de l'application ou du fluide disponible, la nature du fluide caloporteur circulant dans le substrat pourra être par exemple l'eau, les alcools tels que l'éthanol, l'éthylèneglycol, les fluorocarbonés tels que le trichlotrifluoroéthane, les huiles de lubrification et de refroidissement, les huiles minérales, l'essence, le kérosène.

On décrira maintenant différents procédés de fabrication de la carte imprimée à échangeur thermique incorporé conforme à la présente invention.

On réalise tout d'abord séparément un circuit imprimé double faces ou multicouches en stratifié verre époxy mince de préférence selon la technique bien connue, ainsi que le drain thermique.

Le drain thermique conforme à la présente invention est obtenu de la manière suivante. Une plaque, de préférence métallique, est gravée par attaque chimique pour obtenir un réseau de canaux selon un dessin propre au format de la carte, à l'implantation et à la nature des composants qui devront être portés sur celle-ci. Cette plaque est en aluminium ou ses alliages, cuivre, acier, fer, nickel, titane avec en général un coefficient de dilatation compatible avec celui des céramiques. Eventuellement, cette plaque peut être réalisée en matière plastique. On réalise soit simultanément par attaque chimique au cours de la même opération que la gravure des canaux soit ultérieurement par perçage effectué à l'aide de la même bande de commande numérique de la machine outil de perçage que le circuit imprimé qui lui est associé, le perçage des trous mécaniques et éventuellement des trous de connexion à travers lesquels passeront les connexions des composants de la carte imprimée.

Selon d'autres procédés de fabrication, les canaux peuvent être également usinés par fraisage sur machines à commande numérique lorsque les quantités à produire sont faibles ou au contraire lorsque les quantités à produire sont très importantes, il est possible de réaliser la plaque munie du réseau de canaux par moulage d'une matière plastique adéquate telle que par exemple le polyéthersulfone, le polyétherimide, le polysulfone ou par une opération combinée de poinçonnage-emboutissage à partir d'un flanc en tôle métallique ou d'une feuille de matière plastique déformée à chaud.

On réalise ensuite les trous de la plaque de fermeture qui est constituée en général par une plaque métallique présentant éventuellement un coefficient de dilatation contrôlé. Ces trous sont soit gravés chimiquement avec un masque identique à celui utilisé pour la plaque munie du réseau de canaux sans le dessin des canaux, soit percés à l'aide de la même bande de commande numérique que celle du circuit imprimé.

La plaque de fermeture peut être également réalisée par un circuit imprimé mono ou multicouches réalisé sur tissu verre époxy par exemple et dont la face venant contre la plaque de canalisation est entièrement métallisée avec du cuivre par exemple. Ce circuit imprimé peut être celui qui assure toutes les interconnexions électriques de la carte cumulant ainsi les deux fonctions plaque de fermeture et interconnexions électriques.

La plaque de fermeture est ensuite assemblée avec la plaque munie du réseau de canaux de manière connue en soi, soit par contrecollage à l'aide d'une colle époxy par exemple, soit en intercalant entre les deux un tissu de verre époxy du type imprégné à l'aide d'une résine époxy pré-polymère, le passage en température de l'ensemble maintenu pressé réalisant la solidarisation des deux plaques et l'étanchéité du réseau de canalisation. Dans le cas de la deuxième solution, le tissu pré-imprégné aura de préférence subi au préalable une découpe correspondant totalement ou partiellement au dessin du réseau de canalisation.

Les deux trous constituant les orifices d'entrée et de sortie du fluide caloporteur dans le drain thermique peuvent être percés après l'assemblage pour assurer un bon positionnement par rapport aux trous de fixation de la fiche du connecteur. Cependant, il est recommandé de réaliser un avant-trou avant l'assemblage pour éviter les phénomènes de surpression ou de dépression dans les canalisations lorsque les opérations de collage sont réalisées à chaud. En fonction de la face choisie de la carte imprimée pour effectuer le raccordement fluidique, les orifices d'entrée et de sortie seront percés soit dans la plaque de fermeture, soit dans la plaque munie du réseau de canaux.

La fabrication du drain thermique étant terminée, la dernière étape pour obtenir la carte imprimée conforme à la présente invention consiste à assembler le drain et le circuit imprimé. Lorsque tous les composants sont brasés à plat sur le substrat, le circuit imprimé est assemblé avec le drain thermique de la même manière que celle décrite précédemment pour l'assemblage de la plaque de fermeture avec la plaque de canalisation.

Lorsque certains composants sont brasés avec des pattes de connexion traversant la carte imprimée conforme à la présente invention, la surface du drain et ses trous de connexion doivent être isolés électriquement. Cette isolation électrique peut être réalisée selon la technique décrite dans la demande de brevet français 82.05253.

On obtient donc ainsi une carte imprimée comportant un réseau de circulation de fluide caloporteur placé en parallèle sur le réseau d'interconnexions électriques qui conserve une présentation extérieure identique à celle des cartes à drain thermoconducteur conventionnelles. En particulier, son épaisseur est comprise entre 1,8 et 2,2mm. En effet, les techniques de fabrication du drain thermique employées permettent la réalisation d'un drain thermique présentant une épaisseur équivalente à celles des drains thermo-conducteurs. Toutefois, la carte imprimée conforme à la présente invention permet d'améliorer considérablement l'évacuation des calories dissipées par les composants prévus surla carte. A titre d'exemple, l'application de la présente invention sur des prototypes de coffrets équipés de cartes formats 163 x 87,5 mm a permis de vérifier que la puissance maximale dissipable se trouve ainsi multipliée par :

- un facteur 6 par rapport à celle permise dans le même coffret refroidi par convection naturelle

- un facteur 2 par rapport à celle permise dans le même coffret refroidi par conduction avec carte à drain thermoconducteur et connecteur guide-carte thermique.

0197817

## REVENDICATIONS

1. Carte imprimée à échangeur thermique incorporé comprenant, solidaires l'un de l'autre, un circuit mono ou multicouches et un drain thermique (10,11) comportant un système de canalisation (17) permettant la circulation d'un fluide caloporteur, caractérisée en ce que le drain thermique comportant le système de canalisation est constitué d'une plaque (10) munie d'un réseau de canaux (17) et d'une plaque de fermeture (11), les deux plaques étant solidaires l'une de l'autre.

2. Carte imprimée selon la revendication 1, caractérisée en ce que le réseau de canaux est un réseau série constitué par un seul canal continu en forme de méandres (17,18).

3. Carte imprimée selon la revendication 1, caractérisée en ce que le réseau de canaux est un réseau parallèle constitué de plusieurs canaux (24) parallèles entre eux débouchant dans deux canaux latéraux (23) communs à tous les canaux (24).

4. Carte imprimée selon l'une des revendications précédentes, caractérisée en ce que la plaque de fermeture (11) ou la plaque (10) munie du réseau de canaux comporte, à chaque extrémité (15,16) du réseau de canaux (17), un orifice (25") permettant le raccordement dudit réseau à un dispositif d'alimentation en fluide caloporteur, chacun des orifices étant prévu sur une bordure (27) de la carte, ladite bordure comportant également des emplacements de connexion électrique.

5. Carte imprimée selon l'une des revendications précédentes, caractérisée en ce qu'elle comporte, entre la plaque de fermeture (11) et la plaque (10) munie du réseau de canaux, une couche (12) de solidarisation et d'étanchéité.

6. Carte imprimée selon la revendication 5, caractérisée en ce que la couche de solidarisation et

16 0197817

d'étanchéité est réalisée par un tissu de verre époxy pré-imprégné.

7. Carte imprimée selon l'une des revendications 5 ou 6, caractérisée en ce que la couche (12) de solidarisation et d'étanchéité est munie d'une découpe correspondant totalement ou partiellement au dessin du réseau de canaux.

8. Carte imprimée selon l'une des revendications précédentes, caractérisée en ce que la plaque de fermeture (11), est constituée par un circuit imprimé mono ou multicouches réalisé sur un substrat isolant dont une des faces est entièrement métallisée, la face métallisée venant contre la plaque (10) munie du réseau de canaux.

9. Carte imprimée selon l'une des revendications précédentes, caractérisée en ce que la plaque (10) munie du réseau de canaux est réalisée en métal ou en une matière plastique moulable ou déformable à chaud telle que le polyethersulfone, le polyéthérimide, le polysulfone.

10. Carte imprimée selon l'une des revendications précédentes, caractérisée en ce que la plaque de fermeture (11) est réalisée en métal.

11. Carte imprimée selon l'une des revendications 9 ou 10, caractérisée en ce que, lorsque certains composants à reporter sont montés dans des boîtiers céramiques à plots de connexion brasés à plat, la plaque (10) munie du réseau de canaux et la plaque de fermeture (11) sont réalisées en un matériau à coefficient de dilatation thermique adapté à celui de la céramique tel qu'un alliage fer-nickel à 42% de nickel.

12. Carte imprimée selon l'une des revendications précédentes, caractérisée en ce que le drain thermique est muni, en dehors du système de canalisation, d'une pluralité de trous (19) placés sous les boîtiers pour le passage d'une pâte de conduction thermique.

13. Carte imprimée selon l'une des revendications précédentes, caractérisée en ce que le drain thermique (10,11) et le circuit imprimé (14) comportent une pluralité de trous (100) de connexion, le drain thermique comportant sur la surface en contact avec les composants des zones (170) revêtues de résine isolante et des zones (171) non revêtues de résine isolante et les trous (100) du drain thermique étant revêtus de résine isolante.

14. Carte imprimée selon l'une des revendications précédentes, caractérisée en ce qu'elle comporte entre la carte imprimée et le drain thermique une couche (13) de solidarisation.

15. Carte imprimée selon l'une des revendications précédentes, caractérisée en ce que son épaisseur est comprise entre 1,8 et 2,2mm.

FIG_1

0197817

## FIG_2

## FIG_3

# FIG_4

# FIG_5

Office européen
des brevets

**RAPPORT DE RECHERCHE EUROPEENNE**

0197817

Numéro de la demande

EP 86 40 0529

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | DE-A-3 329 325 (HERREN)<br>* Figure 1; page 4, alinéa 6; page 5, dernier alinéa - page 6, alinéa 1 *<br>--- | 1,3 | H 05 K 7/20 |
| X | US-A-3 956 673 (LOCKHEED)<br>* Figure 1; colonne 4, ligne 64 - colonne 5, ligne 4 *<br>--- | 1,5,6 | |
| A | US-A-4 019 098 (SUNDSTRAND CO.)<br>* Figure 3; colonne 3, ligne 64 - colonne 4, ligne 5 *<br>--- | 1,5 | |
| A | IBM TECHNICAL DISCOSURE BULLETIN, vol. 26, no. 2, juillet 1983, page 841, New York, US; J.M. ELDRIDGE et al.: "Fluid assembly for high speed chip cooling"<br>--- | 1,3,4,8 | DOMAINES TECHNIQUES RECHERCHES (Int. Cl.4)<br><br>H 05 K |
| A,D | EP-A-0 090 727 (SOCAPEX)<br>----- | | |

Le présent rapport de recherche a été établi pour toutes les revendications

| Lieu de la recherche | Date d'achèvement de la recherche | Examinateur |
|---|---|---|
| LA HAYE | 01-07-1986 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82